Europäisches Patentamt

European Patent Office

Office européen des brevets

(11) Publication number: **0 350 539**
**A1**

## EUROPEAN PATENT APPLICATION

(21) Application number: **88201534.0**

(22) Date of filing: **15.07.88**

(51) Int. Cl.⁴: **H01J 37/317**

(43) Date of publication of application:
**17.01.90 Bulletin 90/03**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Möllenstedt, Gottfried**
**c/o Internationaal Octrooibureau B.V.**
**Prof. Holstlaan 6 NI-5656 AA Eindhoven(NL)**
Inventor: **Keuzer, Peter Michael**
**c/o Internationaal Octrooibureau B.V.**
**Prof. Holstlaan 6 NI-5656 AA Eindhoven(NL)**

(74) Representative: **Scheele, Edial François et al**
**INTERNATIONAAL OCTROOIBUREAU B.V.**
**Prof. Holstlaan 6**
**NL-5656 AA Eindhoven(NL)**

(54) Electron beam micro structure formation.

(57) A method for deposition of a micro-structure with the aid of an electron beam being focused into a narrow cross-section in an in-dept space in an electron beam apparatus which is slowly scanned in a line-wise pattern such that through deposition of material present in the apparatus a multi-pattern of elements is deposited on or beyond a support. A lot of individual mutual equal wires can be formed during a single scan, one behind the other in a direction of electron beam. It is also possible to deposite wires (or columns of wires) of mutually different thickness on beside the other by adapting scan-speed gass-pressure, temperature, beam current and or other parameters.

EP 0 350 539 A1

# Electron beam micro structure formation.

The invention relates to a method for micro-structure production and to a micro-structure thus produced.

It is known that in electron beam apparatus contamination is introduced by the electron beam especially on non-heated objects such as non-heated specimens to be examined. This contamination, which in fact means deposition of material present in the apparatus onto objects, is normally disadvantageous because surfaces to be examined are no longer clean but become covered with material detoriating good imaging or analysing of the specimen.

It is an object of the invention to make an advantageous use of contamination phenomena for the formation of useful micro-structures. To this end the afore mentioned method in accordance with the invention is characterized in that, in an electron beam apparatus an electron beam of controllable beam-current, focused into a small cross-section is slowly scanned over a deposit ion space such that through deposition of material present in the apparatus a micro-structure is deposited.

Very surprisingly self supporting wires can be formed in an open space in an electron microscope by scanning in an adapted manner byond the boundary of a support such as a foil or aperture plate positioned in a dept-of-focus space in which the electron beam is focused into a relatively narrow spot or micro probe.

In a preferred embodiment the support is ring shaped and wires are formed from an inner boundary up to an opposite inner boundary thereof. Thus self supporting grid structures with a fine pitch and thin wires can be realised.

According to a further embodiment of the invention a grid structure composed of wires one behind the other in a direction of the electron beam is formed with an adapted electron velocity and scanning speed of the electron beam. The mutual distance of the wires being controllable also by way of the gas pressure in the apparatus and the temperature to the support. Within this method several grid structures one beside the other can be produced. These structures can be divided into a lot of two dimensional grid structures or can be used as three dimensional grid structures for diffractometry, X-ray analyses etc. The method also enables the production of grid structures in which grid properties vary locally over the structure. Thus electron beam, UV-beam and soft X-ray beam lenses can be produced, preferably cylindrical lenses to be used per se or in a crossed combination of two of them.

In a further embodiment a grid structure is formed with a multi-element structure deposited on the surface of a support resulting in a very regular and well defined distribution of fine lines or points such as for multi-connections.

Grid structure produced according to the invention can be self supporting and the wires thereof substantially consist of carbon, carbon-polymers, other elements or chemical bonds. Grids can be formed having a wire thickness as low as 10 nm and a pitch for example of about 10-50 nm.

A supporting foil for a structure produced in accordance with the invention consists preferably of carbon, aluminium, silver, gold, indium, germanium or silicon etc.

A three dimensional self supporting grid structure can be used as an anlysing crystal for X-ray diffraction measurings and can also be used as an X-ray optical element for directing and focusing X-ray beams.

A self supporting two dimensional grid structure can be used as a grating for electrons, X-ray and neutron diffraction etc.

A multi element structure deposited on the surface of, for example a silicon wafer, can be formed as a multi electron or ion source element, as a matrix of connection points etc.

Preferred embodiments in accordance with the invention will be described in more detail hereinafter with reference to the accompanying drawing in which:

Figure 1 is a diagrammatic set-up of an apparatus to exploit the method and

Figures 2, 3 and 4 show examples of structures produced in accordance with the invention.

For the production of contamination micro-structures, such as self-supporting contamination filaments, an electron beam micro- recorder as shown in the drawing can be used. The apparatus is provided with an electron gun comprising a triode system 2 with a thermal pointed tungsten cathode 3 and an anode 4. In full-beam operation the electron source supplies a brightness of for example $2.10^5$ A/cm²sr at very high current stability. For the production of contamination filaments, an accelerating voltage of about 50 kV and a probe current of about $10^{-9}$ A are applicable. An electron probe, for example 60 nm in diameter, was produced by a preliminary demagnification in two steps using two condenser lenses 6 and 8, and an additional final demagnification one-field condenser-objective lens 10. The third condenser lens is, outside the vacuum, equipped with a stigmator 12 for correction of axial stigmatism and a double-deflection system 14 for writing contamination filaments. Below the third lens a Faraday cage 15 may be swiveled across the beam to measure the probe current, and a final image screen can be placed at some distance. In front of and behind a first lens, beam limiting aperture 16 are placed in order to intercept non-paraxial electrons the trajectories of which may suffer from third-order aberrations. An additional aperture 18 is placed within the third demagnifying lens. Both condenser lenses may be aligned from outside. A blanking system 20 consisting of two deflector plates 21 and a blanking aperture 22 is placed between the two condenser lenses 6 and 8.

The column can be evacuated using a conventional vacuum pumping system consisting of, for example, a mechanical forepump and an oil diffusion punp which allow to attain a final pressure of, for example, about $10^{-3}$ Pa. In a deposition space 25 a ring-shaped electron detector 26 and a substrate 28 are positioned. The physical nature of the substrate surface and the shape of the edge from which the filaments are growing play and important role in the growth of self-supporting contamination filaments.

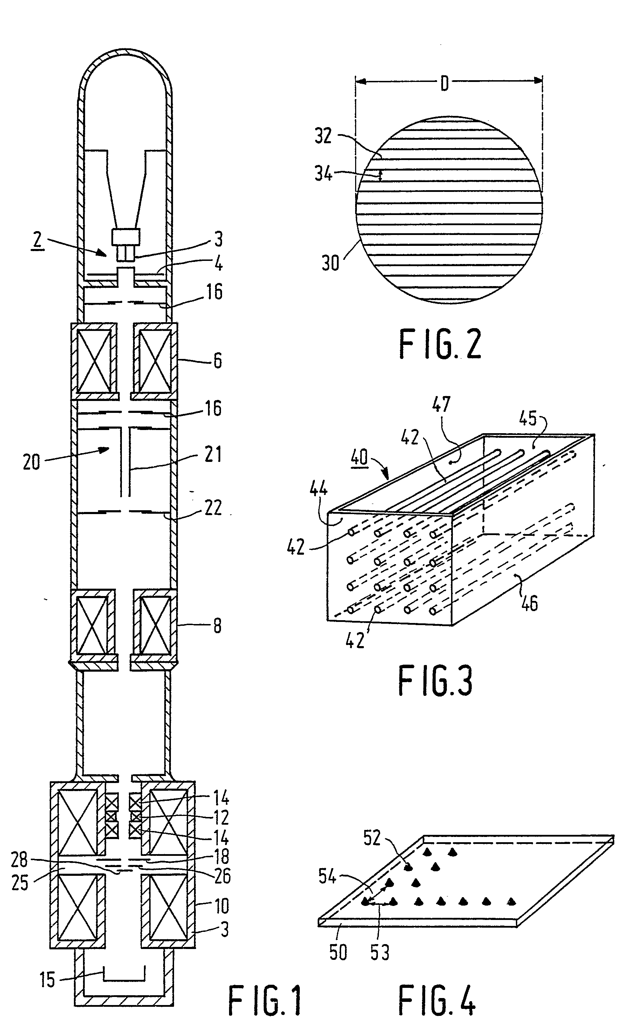

An unclean or rounded edge as well as a rough surface may result in failure of perfectly focusing the electron beam on the surface. This may in turn lead to the absence of a contamination filament or the appearance of just a short accretion instead of a long filament when a slow line scan of the probe across the edge is performed. The commercially available platinum apertures proved to be less suitable for our original purpose of producing long single filaments. Instead of the expected single contamination filament, the line scan produced, depending on the writing speed and the cleanness of the edge, a system of up to 20 filaments 30 below each other, as shown in Figure 3.

When use is made of thin layer apertures of about 200 to 500 nm in thickness consisting of carbon foils covered by vacuum deposited Ag and Au layers, the number of contamination filaments still varied from two to six, depending on the writing speed of the line scan, but was clearly smaller than with the platinum apertures with their cylindrical bores about 20 $\mu$m in length. The appearance of at least two filaments below each other can be understood as follows: since the thin layer apertures are thin enough to be penetrated by 50 keV electrons, the filaments start growing on the upper as well as on their lower surface.

A comparison of contamination filaments written on platinum and thin layer apertures under otherwise equal conditions shows that the filaments growing on platinum are wider and thicker by a factor of 1.5 to 2 as compared to those grown on thin layer apertures. We denote by "width" the lateral dimension of the filament and by "thickness" their dimension in the direction of the electron beam. There were no significant differences in length between the filaments obtained with the two types of apertures.

The apparently greater rate of contamination with the platinum apertures may be explained as follows: due to the greater thickness of the platinum apertures the surface in the immediate neighbourhood of the electron probe and hence the supply of contaminent molecules migrating on the surface diffusion is greater than in the case of the thin layer apertures.

With a pressure of $4.10^{-3}$ to $9.10^{-3}$ Pa a probe current $I_s$ of $10^9$ A a substrate temperature of $18\,^{\circ}$C and an acellerating volge of 50 kV, the writing speed can be varied between about 2 nm and 20 nm per second for example.

Figure 2 shows a grid 30 consisting a single layer of contamination wires 32 having a thickness of for instance 100 nm or smaller separated from one another over distances of a low as 40 nm up to arbitrary higher spacings. Such grid structures can be used as gratings. The pitch 34 can be adapted to the radiation over a wide traject. Grids can be produced having dimensions up to about 100 $\mu$m.

Figure 3 shows a three dimensional grid structure 40 with contamination wires 42 forming a regular wire pattern between two support faces 44 and 45 preferably connected for the sake of solidity with side faces 46 and 47.

All the wires 42 can be deposited in a single deposition action thus without destroying the vacuum in the apparatus. Columns of wires in a single scan one behind the other as explained and rows on different scanning lines. Mutual distances between columns and rows thus need not to be similar but the parameters can be controlled thus that they indeed are equal if desired. Such structures can be used for X-ray bending in X-ray analysis and as lenses for radiation having a wavelength to which the pitches of the structure can be adapted. Introducing a slope in the thickness of the wires with respect to one-another results in cylinder lenses for adapted radiation.

Figure 4 shows a sheet 50 of, for example, a semi-conductor material on which a pattern of contamination points 52 are deposited in the electron microscope aparatus. Mutual distances 53 and 54 can be chosen arbitrary up from very small values in the nm region. The dots 52 can but need not to be regularly deposited over the surface. Such dots can be used in the production of multi-source electron or ion emitters especially as field emitters therein. Just as a pattern of dots a pattern of parallel lines or a cross-bar structure can be deposited for example for a pointwise control of a multi-element device.

## Claims

1. A method for micro-structure production, characterized in that in an electron beam apparatus an electron beam, focused into a narrow cross-section is slowly scanned in a line-wise pattern such that through deposition of material present in an in-dept focus space in the apparatus a micro-structure is formed.

2. The method as claimed in Claim 1, characterized in that in the in-dept focus space a ring shaped is positioned defining an opening in which self-supporting conductive elements are deposited by scanning the beam byond an inner support boundary.

3. The method as claimed in Claim 2, characterized in that the grid structure is deposited in a line-wise grow-up proces the thickness and the pitch of elements of the structure deposited being stipulated by the electron beam cross-section and the scanning pattern and scanning speed.

4. The method as claimed in Claim 2, characterized in that the grid structure is formed by a single line scanning, the wires being formed one behind the other in the direction of the electron beam.

5. The method as claimed in Claim 2, 3 or 4, characterized in that the mutual thickness of the wires is changed in a direction perpendicular to the direction of scanning.

6. The method as claimed in Claim 2, 3, 4 or 5, characterized in that the grid structure is self supporting within an opening in a supporting foil.

7. The method as claimed in Claim 1, characterized in that a multi-element structure is deposited on the surface of a support.

8. The method as claimed in Claim 7, characterized in that the multi-element structure defines a two dimensional pattern of elements having a mutual distance below about 100 nm and a cross section below about 25 nm.

9. The method as claimed in anyone of the preceeding claims, characterized in that the structure is deposited with a 50 kV, $10^{-9}$ A, electron beam focused into cross-section of about 25 nm being scanned with a speed of about 5 nm per second over or byond a support where a pressure of about $10^{-3}$ pa exists.

10. Grid structure deposited by the method as claimed in anyone of the Claims 2 through 6 or 9.

11. Grid structure as claimed in Claim 10, characterized in that the grid wires consist substantially of carbon, polymers or organic-metal bonds.

12. Multi element structure deposited by the method as claimed in Claim 1, 7, 8 or 9.

13. Multi element structure as claimed in Claim 10, 11 or 12, characterized in that grid wires have a thickness of about 25 nm with a pitch of about 100-500 nm.

14. Multi element structure as claimed in Claim 10, 11, 12 or 13, characterized in that the supporting foil mainly consists of a material of the group comprising carbon, aluminium, silver, gold, indium, germanium and silicon.

15. Multi element structure as claimed in Claim 13 or 14, charaoterized in that it forms part of a microminiature, multi-source electron or ion beam device.

FIG.2

FIG.3

FIG.1

FIG.4

European Patent Office

EUROPEAN SEARCH REPORT

Application Number

EP 88 20 1534

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | JOURNAL OF VACUUM SCIENCE & TECHNOLOGY/SECTION B, vol. 6, no. 1, second series, January/February 1988, pages 477-481, American Vacuum Society, Woodbury, NY, US; H.W.P. KOOPS et al.: "High-resolution electron-beam induced deposition" * Page 477, paragraph I; page 480, paragraph IV-C; figure 5; page 481, figure 6a; paragraph VI * --- | 1-3,6,8 ,9,11- 14 | H 01 J 37/317 |
| X | OPTIK, vol. 78, no. 4, March 1988, pages 158-164, Wissenschaftliche Verlagsgellschaft mbH, Stuttgart, DE; p. KREUZER: "Formation and examination of self-supporting contamination filaments" * Whole article * --- | 1-15 | |
| A | APPLIED PHYSICS LETTERS, vol. 29, no. 9, 1st November 1976, pages 596-598, American Institute of Physics, New York, US; A.N. BROERS et al.: "Electron-beam fabrication of 80-A metal structures" * Whole article * --- -/- | 3,7,8, 11,13, 14 | TECHNICAL FIELDS SEARCHED (Int. Cl.4) H 01 J 37/00 |

The present search report has been drawn up for all claims

| Place of search | Date of completion of the search | Examiner |
|---|---|---|
| THE HAGUE | 13-03-1989 | SCHAUB G.G. |

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| A | PROCEEDINGS OF THE XITH INTERNATIONAL CONGRESS ON ELECTRON MICROSCOOPY, Kyoto, 31st August - 7th September 1986, vol. 35, suppl., 1986, pages 667-668, The Japanese Society of Electron Microscopy, Tokyo, JP; J. LINDERS et al.: "Production of special microstructures by electron beam contamination lithography and ion beam erosion"<br>* Whole article * | 1,15 | |
| A | JOURNAL OF VACUUM SCIENCE & TECHNOLOGY B, vol. 5, no. 5, second series, September/October 1987, pages 1427-1431, American Vacuum Society, Woodbury, NY, US; R.R. KUNZ et al.: "Selective area deposition of metals using low-energy electron beams" | | |
| | | | TECHNICAL FIELDS SEARCHED (Int. Cl.4) |

The present search report has been drawn up for all claims

| Place of search | Date of completion of the search | Examiner |
|---|---|---|
| THE HAGUE | 13-03-1989 | SCHAUB G.G. |

EPO FORM 1503 03.82 (P0401)